# EUROPÄISCHE PATENTSCHRIFT

(11) **EP 2 288 246 B1**
(45) Veröffentlichungstag und Bekanntmachung des Hinweises auf die Patenterteilung: **02.03.2016**
(21) Anmeldenummer: 10006523.4
(22) Anmeldetag: 23.06.2010
(51) Int. Cl.: H05K 7/14, H02M 7/00

(54) **Leistungshalbleitermodul und Verfahren zur Montage eines Leistungshalbleitermoduls**
High-performance semiconductor and method for installing same
Module semi-conducteur de puissance et procédé de montage d'un module semi-conducteur de puissance

(30) Priorität: 21.08.2009 DE 102009028814
(43) Veröffentlichungstag der Anmeldung: 23.02.2011
(73) Patentinhaber: SEMIKRON Elektronik GmbH & Co. KG, 90431 Nürnberg (DE)
(72) Erfinder: Hüttmeier, Simon, 91729 Haundorf (DE); Popp, Rainer, 91580 Petersaurach (DE)

(56) Entgegenhaltungen:
- EP-A2- 1 978 557
- DE-A1- 4 111 247
- DE-A1- 4 237 632
- DE-A1-102006 006 421

## Beschreibung

Die Erfindung betrifft ein Leistungshalbleitermodul nach dem Oberbegriff des Anspruchs 1. Sie betrifft ferner ein Verfahren zur Montage eines solchen Leistungshalbleitermoduls.

Aus der DE 10 2007 006 212 A1 ist ein Leistungshalbleitermodul bekannt, bei dem auf einer Grundplatte eine mit Leistungshalbleitern bestückte Leistungshalbleiterplatine aufliegt. Darüber ist ein Zwischenstück gestapelt, welches Ausnehmungen zur Aufnahme von Kontaktfedern aufweist. Die Kontaktfedern werden gegen auf der Leitungshalbleiterplatine vorgesehene Kontaktflächen gedrückt. Ein gegenüberliegendes Ende der Kontaktfedern ragt aus den Ausnehmungen im Zwischenstück hervor. Darauf kann beispielsweise eine eine Steuerschaltung aufweisende Steuerplatine montiert werden. Ein elektrischer Kontakt zwischen der Steuerplatine und der Leistungshalbleiterplatine kann durch ein Inkontaktbringen von auf der Steuerplatine vorgesehenen weiteren Kontaktflächen mit den Kontaktfedern erreicht werden. Das bekannte Leistungshalbleitermodul lässt sich relativ einfach und schnell montieren. Wegen des Vorsehens von Kontaktfedern ist es vorteilhafterweise nicht erforderlich, Lötverbindungen herzustellen.

Bei der Montage der Steuerplatine wird diese entgegen einer von der Elastomermatte und den Kontaktfedern erzeugten Kraft gegen eine Oberseite des Zwischenstücks gedrückt und nachfolgend beispielsweise mittels Schraubverbindungen fixiert. Dazu muss eine relativ hohe Kraft auf die Steuerplatine ausgeübt werden. Dabei kann es zu einer Beschädigung der Steuerplatine kommen. Eine solche Beschädigung ist optisch nicht immer erkennbar. Sie fällt häufig erst bei einer Prüfung der elektrischen Funktionsfähigkeit des Leistungshalbleitermoduls auf. Eine Reparatur oder gar ein Aussondern eines nicht ordnungsgemäß funktionierenden Leistungshalbleitermoduls erfordert Kosten- und Zeitaufwand.

Aus der DE 10 2006 006 421 A1 ist ein Leistungshalbleitermodul mit mindestens einem Substrat, mindestens einem hierauf angeordneten Leistungshalbleiterbauelement, einem Gehäuse, einem ersten Kunststoffformkörper, nach außen führenden Anschlusselementen und einem zweiten Kunststoffformkörper, bekannt

Aus der DE 42 37 632 A1 ist eine Schaltungsanordnung mit einem Kühlbauteil mit mindestens einer Trägerplatte, die auf einem Kühlbauteil angeordnet ist, bekannt.

Aufgabe der Erfindung ist es, die Nachteile nach dem Stand der Technik zu beseitigen. Es soll insbesondere ein Leistungshalbleitermodul angegeben werden, welches mit einer geringen Beschädigungs- und/oder Ausschussrate herstellbar ist. Ferner soll ein möglichst einfach durchführbares Verfahren zur Herstellung eines solchen Leistungshalbleitermoduls angegeben werden.

Diese Aufgabe wird durch die Merkmale der Ansprüche 1 und 10 gelöst. Zweckmäßige Ausgestaltungen der Erfindung ergeben sich aus den Merkmalen der Ansprüche 2 bis 9 und 11 bis 17.

Nach Maßgabe der Erfindung wird bei einem Leistungshalbleitermodul vorgeschlagen, dass das Zwischenstück mehrteilig ausgebildet ist und ein der Grundplatte zugewandtes Basisteil sowie ein der Steuerplatine zugewandtes Topteil aufweist, wobei das Topteil eine erste Befestigungseinrichtung zum Befestigen der Steuerplatine und eine zweite Befestigungseinrichtung zum Befestigen am Basisteil aufweist.

Indem das Zwischenstück mehrteilig, vorzugsweise zweiteilig, ausgebildet ist, kann das Basisteil entgegen der von der Elastomermatte erzeugten erheblichen Kraft gegen die Grundplatte gedrückt und relativ zur Grundplatte befestigt werden. Unabhängig davon kann die Steuerplatine am Topteil befestigt werden. Eine aus dem Topteil und der Steuerplatine gebildete Montageeinheit ist robust und kann ohne die Gefahr einer Beschädigung der Steuerplatine mittels der daran vorgesehenen zweiten Befestigungseinrichtung am Basisteil montiert werden. Zur Montage der Montageeinheit ist es lediglich erforderlich, die durch die Federelemente erzeugte Kraft zu überwinden. Diese ist im Vergleich zu der durch die Elastomermatte erzeugten Kraft wesentlich geringer. Das vorgeschlagene Leistungshalbleitermodul kann mit einer besonders geringen Reparatur- und/oder Ausschussrate hergestellt werden. Das Topteil ist insbesondere so ausgestaltet, dass eine unmittelbare Ausübung einer Kraft auf die Steuerplatine bei der Montage auf das Basisteil vermieden wird.

Das Basisteil und das Topteil sind hinsichtlich eines wesentlichen Teils ihrer darin vorgesehenen Durchbrüche und/oder Ausnehmungen korrespondierend ausgebildet. Insbesondere die ersten Ausnehmungen können anteilig im Top- und im Basisteil gebildet sein. D. h. die Kontaktfedern erstrecken sich in den ersten Ausnehmungen sowohl im Top- als auch im Basisteil.

Nach einer zweckmäßigen Ausgestaltung der Erfindung weist die erste Befestigungseinrichtung zweite Ausnehmungen zur Befestigung, vorzugsweise selbstschneidender, Schrauben auf. Das ermöglicht eine lösbare Befestigung der Steuerplatine auf dem Topteil. Selbstverständlich kann die erste Befestigungseinrichtung auch anders ausgestaltet sein. Es kann sich dabei auch um eine mit Rastfedern versehene Rastvorrichtung handeln.

Die zweite Befestigungseinrichtung ist vorteilhafterweise eine Rasteinrichtung. Die Rasteinrichtung kann mehrere am Topteil angebrachte Rastzungen umfassen, welche korrespondierend zu am Basisteil vorgesehenen Rastausnehmungen ausgebildet sind. Nach einer besonders vorteilhaften Ausgestaltung ist die Rasteinrichtung so ausgebildet, dass eine damit hergestellte Rastverbindung zwischen dem Top- und dem Basisteil nicht zerstörungsfrei lösbar ist. Mit der vorgeschlagenen Rasteinrichtung kann das Topteil schnell und einfach durch Ausüben eines geeigneten Drucks bzw. einer geeigneten Kraft mit dem Basisteil verrastet werden. Indem die einmal hergestellte Rastverbindung nicht zerstörungsfrei lösbar ist, kann eine unerwünschte Manipulation, insbesondere ein Lösen der Verbindung zwischen Top- und Basisteil, sofort erkannt werden. Damit kann die Qualitätssicherung verbessert werden.

Nach einer weiteren Ausgestaltung sind im Basisteil dritte Ausnehmungen zur Aufnahme von Bauelementen, vorzugsweise zur Aufnahme zylindrischer Kondensatoren, vorgesehen. Die dritten Ausnehmungen sind zweckmäßigerweise zylindrisch ausgeführt und erstrecken sich im Wesentlichen senkrecht zur Grundplatte. Im Topteil können zu den dritten Ausnehmungen korrespondierende vierte Ausnehmungen zur Aufnahme der Bauelemente vorgesehen sein. Auch die vierten Ausnehmungen sind zweckmäßigerweise zylindrisch ausgebildet. In die vierten Ausnehmungen kann sich jeweils zumindest eine, vorzugsweise zwei, Federzunge/n erstrecken. Mit den Federzungen wird im Montagezustand ein Druck auf die in den dritten und vierten Ausnehmungen aufgenommenen Bauelemente, insbesondere Kondensatoren, ausgeübt. Damit werden die Bauelemente kraftschlüssig in einer aus den dritten und vierten Ausnehmungen gebildeten Gesamtausnehmung gehalten.

Zwischen der Leistungshalbleiterplatine und dem Basisteil in übereinanderliegender Anordnung sind zumindest eine Anschlussplatte, eine die Bauelemente tragende Anschlussplatinenanordnung und eine Elastomermatte angeordnet. Die Elastomermatte dient der Ausübung einer dauerhaft wirksamen Kraft, mit der die Anschlussplatinenanordnung beispielsweise gegen die Anschlussplatte zur Herstellung eines elektrischen Kontakts gedrückt wird. Desgleichen kann die Anschlussplatte damit auch in Kontakt mit der Leistungshalbleiterplatine gehalten werden. Abgesehen davon kann durch das Zusammenwirken des Basisteils mit der Elastomermatte auch die Leistungshalbleiterplatine unter einer Vorspannung in Anlage mit der Grundplatte gehalten werden.

Indem das Basisteil unter Zwischenschaltung der Elastomermatte unter Druck mit der Grundplatte verbunden wird, kann schnell und einfach eine weitere Montageeinheit hergestellt werden, welche mit der oben erwähnten aus Topteil und Steuerplatine gebildeten Montageeinheit verbunden werden kann.

Nach weiterer Maßgabe der Erfindung wird ein Verfahren zur Montage eines erfindungsgemäßen Leistungshalbleitermoduls mit folgenden Schritten vorgeschlagen:
Herstellen einer ersten Montageeinheit durch Befestigen der Steuerplatine am Topteil,
Anordnen der zumindest einen Leistungshalbleiterplatine auf der Grundplatte,
Herstellen einer zweiten Montageeinheit durch Anordnen des Basisteils über der Leistungshalbleiterplatine und Befestigen des Basisteils an der Grundplatte, und
Drücken der ersten Montageeinheit gegen die zweite Montageeinheit mit einer vorgegebenen Kraft, so dass in den ersten Ausnehmungen aufgenommene Kontaktfedern komprimiert werden, und währenddessen Befestigen des Topteils am Basisteil.

Mit dem vorgeschlagenen Verfahren kann sicher und zuverlässig eine Beschädigung der Steuerplatine vermieden werden. Die zur Montage der ersten Montageeinheit erforderliche Kraft kann unmittelbar auf das Topteil ausgeübt werden. Die Kraft zur Montage des Topteils am Basisteil entspricht lediglich der durch das Zusammendrücken der Kontaktfedern erforderlichen Gegenkraft. Erfindungsgemäß wird eine zweite Montageeinheit durch Anordnen des Basisteils über der Leistungshalbleiterplatine und Befestigen des Basisteils an der Grundplatte hergestellt. Zur Herstellung der zweiten Montageeinheit ist es üblicherweise erforderlich, das Basisteil entgegen einer durch eine zwischen der Grundplatte und dem Basisteil befindlichen Elastomermatte gebildeten Rückstellkraft gegen die Grundplatte zu drücken. Durch das Vorsehen einer ersten und einer zweiten Montageeinheit ist es nun nicht mehr erforderlich, auch die zur Herstellung der zweiten Montageeinheit erforderliche Kraft über das Topteil bzw. die darauf angebrachte Steuerplatine einzuleiten.

Ein weiterer Vorteil des erfindungsgemäß vorgeschlagenen Verfahrens besteht darin, dass die erste und die zweite Montageeinheit unabhängig voneinander vor deren Verbindung auf ihre einwandfreie elektrische Funktionsfähigkeit geprüft werden können. Das ermöglicht schon vor der Herstellung der Verbindung ein eventuell notwendiges Aussondern einer defekten Montageeinheit.

Ein weiterer Vorteil der Herstellung einer aus der Steuerplatine und dem Topteil bestehenden ersten Montageeinheit besteht darin, dass die Steuerplatine besser gegen eine Beschädigung auf einem Transportweg zum Montageort geschützt ist.

Nach einer vorteilhaften Ausgestaltung der Erfindung wird das Basisteil mit der Grundplatte verschraubt. Die vorgeschlagene lösbare Verbindung ermöglicht ein Abnehmen des Basisteils von der Grundplatte und einen ggf. erforderlichen Austausch einer defekten Leistungshalbleiterplatine.

In ähnlicher Weise kann auch die Steuerplatine mit dem Topteil mittels einer Schraubverbindung lösbar verbunden werden. Auch das ermöglicht einen eventuell erforderlichen Austausch der Steuerplatine.

Nach einer weiteren Ausgestaltung ist vorgesehen, dass das Basisteil zusammen mit in den ersten Ausnehmungen, vorzugsweise unverlierbar, aufgenommenen Kontaktfedern über der Leistungshalbleiterplatine angeordnet wird. Mit einem derartig vorkonfektionieren Basisteil kann die Montage weiter beschleunigt werden.

Nach einer weiteren Ausgestaltung werden vor dem Anordnen des Basisteils über der Leistungshalbleiterplatine in übereinanderliegender Anordnung zumindest eine Anschlussplatte, eine die Bauelemente, vorzugsweise Kondensatoren, tragende Anschlussplatinenanordnung und eine Elastomermatte angeordnet. Das vorgeschlagene Übereinanderstapeln der weiteren Montagebestandteile des Leistungshalbleitermoduls ermöglicht eine besonders einfache Montage. Zur Herstellung der zweiten Montageeinheit kann das Basisteil mit einer vorgegebenen weiteren Kraft gegen die Grundplatte gedrückt und währenddessen daran befestigt werden. Dabei kann insbesondere die Elastomermatte zusammengedrückt werden. Eine damit bewirkte Spannkraft zwingt die zwischen Basisteil und Grundplatte angeordneten Montagebestandteile gegeneinander, so dass an gewünschten Kontaktpunkten ein elektrischer Kontakt zwischen den Montagebestandteilen hergestellt wird. Die zur Montage des Topteils am Basisteil erforderliche Kraft ist zweckmäßigerweise um den Faktor 10, vorteilhafterweise um den Faktor 50 bis 100, kleiner als die zur Montage des Basisteils an der Grundplatte erforderliche weitere Kraft. Mit dem erfindungsgemäßen Verfahren kann also die Kraft zur Montage des Topteils am Basisteil in ganz erheblicher Weise reduziert werden.

Beim Drücken der ersten Montageeinheit gegen die zweite Montageeinheit kann vorteilhafterweise das Topteil mittels der Rasteinrichtung mit dem Basisteil verrastet werden. Die Herstellung einer solchen Verbindung ist schnell und einfach durchführbar. Dazu ist es nicht erforderlich, Befestigungsmittel und/oder ein Werkzeug bereitzustellen.

Nach einer weiteren vorteilhaften Ausgestaltung des Verfahrens werden die erste und/oder zweite Montageeinheit vor deren Verbindung geprüft. Insbesondere wird geprüft, ob die Montageeinheiten elektrische Vorgaben an definierten Messpunkten erfüllen. Damit kann das Verbauen einer eventuell defekten Montageeinheit in einem frühen Zustand bei der Montage vermieden werden.

Nachfolgend wird ein Ausführungsbeispiel der Erfindung anhand der Zeichnung näher erläutert. Es zeigen:
- Fig. 1: eine perspektivische Ansicht eines Leistungshalbleitermoduls,
- Fig. 2: eine Seitenansicht gemäß Fig. 1,
- Fig. 3: eine Schnittansicht gemäß der Schnittlinie A-A in Fig. 2,
- Fig. 4: eine perspektivische Ansicht einer Steuerplatine,
- Fig. 5: eine Seitenansicht gemäß Fig. 4,
- Fig. 6: eine Schnittansicht gemäß der Schnittlinie A-A in Fig. 5,
- Fig. 7: eine perspektivische Draufsicht auf ein Topteil,
- Fig. 8: eine Unteransicht gemäß Fig. 7,
- Fig. 9: eine perspektivische Draufsicht auf ein Basisteil und
- Fig. 10: eine Unteransicht gemäß Fig. 9.

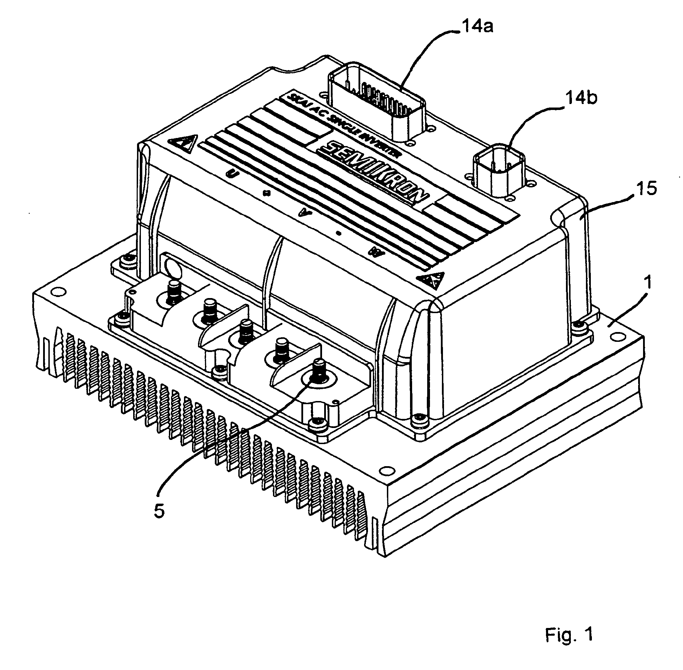

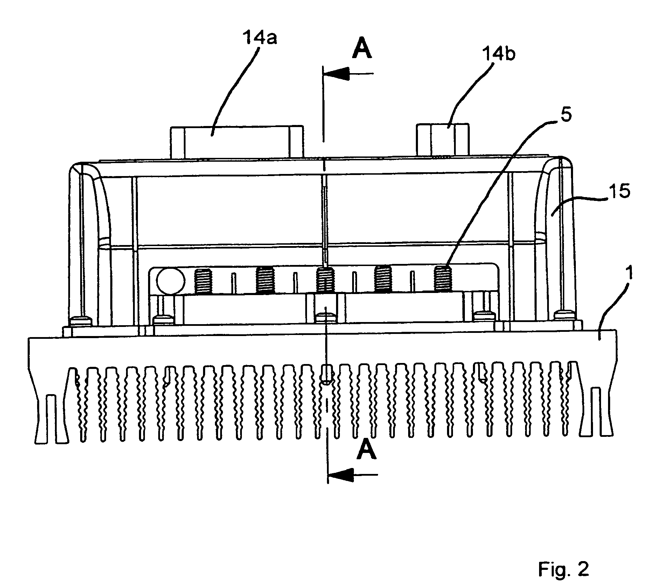

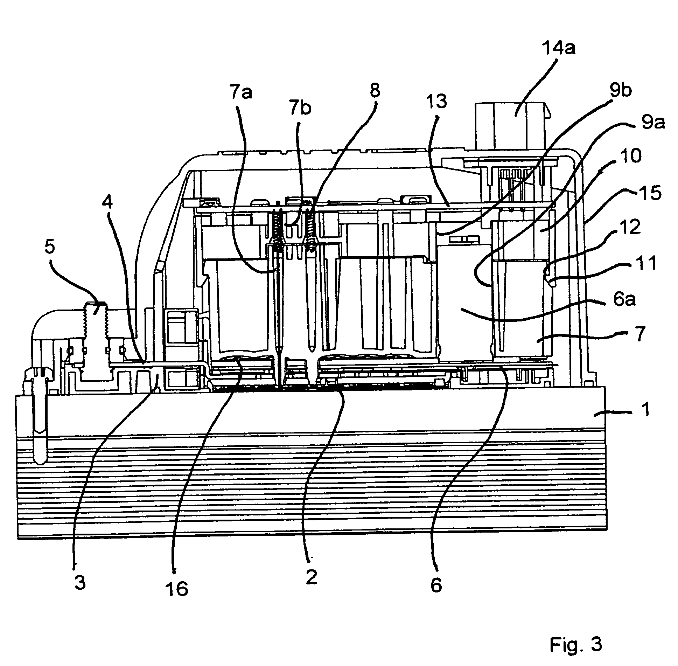

Bei dem in den Fig. 1 bis 3 gezeigten Leistungshalbleitermodul ist auf einer Grundplatte 1, welche hier in Form eines aus Aluminium hergestellten Kühlkörpers ausgestaltet ist, eine mit (hier nicht gezeigten) Leistungshalbleitern bestückte Leistungshalbleiterplatine 2 aufgenommen. Mit dem Bezugszeichen 3 ist ein z. B. aus Kunststoff hergestellter Montagerahmen bezeichnet, welcher die Leistungshalbleiterplatine 2 randlich umgibt. Mit dem Bezugszeichen 4 ist eine, beispielsweise in Form eines Metallstreifens ausgestaltete, Anschlussplatte bezeichnet, welche ein hier als Gewindebolzen ausgestaltetes Anschlusselement 5 elektrisch mit einer Unterseite einer Anschlussplatinenanordnung 6 verbindet. Die Anschlussplatinenanordnung 6 besteht aus einer unteren Platine, welche unter Zwischenschaltung einer Isolationsschicht mit einer oberen Platine verbunden ist. Auf der oberen Platine sind zylindrische Kondensatoren 6a angebracht. Mit dem Bezugszeichen 7 ist ein, beispielsweise aus spritzgegossenem Kunststoff hergestelltes, Basisteil bezeichnet, in dem erste Ausnehmungen 7a mit darin aufgenommenen Kontaktfedern 8 vorgesehen sind. Ferner sind im Basisteil 7 dritte Ausnehmungen 9a vorgesehen, in welche die Kondensatoren 6a eingesteckt sind. Ein mit dem Bezugszeichen 10 bezeichnetes Topteil, welches ebenfalls aus spritzgegossenem Kunststoff hergestellt sein kann, ist mittels Rastzungen 11 in dazu korrespondierenden Rastausnehmungen 12 am Basisteil 7 verrastet. Auf das Topteil 10 ist eine Steuerplatine 13 montiert, welche eine erste Buchse 14a und eine zweite Buchse 14b zum Anschluss (hier nicht gezeigter) Stecker umfasst. Mit dem Bezugszeichen 15 ist ein Gehäuse bezeichnet, welches die vorgenannte Anordnung gemeinsam mit der Grundplatte 1 umschließt.

Zwischen einer Unterseite des Basisteils 7 und einer Oberseite der Anschlussplatinenanordnung 6 befindet sich eine komprimierte Elastomermatte 16, welche die Anschlussplatinenanordnung 6 gegen die darunter befindlichen streifenförmigen Anschlussplatten 4 zwingt. An einer Unterseite der Anschlussplatten 4 vorspringende Kontakte werden damit gleichzeitig gegen die Leistungshalbleiterplatine 2 gezwungen. Die Leistungshalbleiterplatine 2 wird durch die aufgebrachte Spannung wiederum gegen die Grundplatte 1 gezwungen. Es ergibt sich ein sicherer und zuverlässiger elektrischer Kontakt zwischen der Grundplatte 1, der Leistungshalbleiterplatine 2, den Anschlussplatten 4 sowie der Anschlussplatinenanordnung 6.

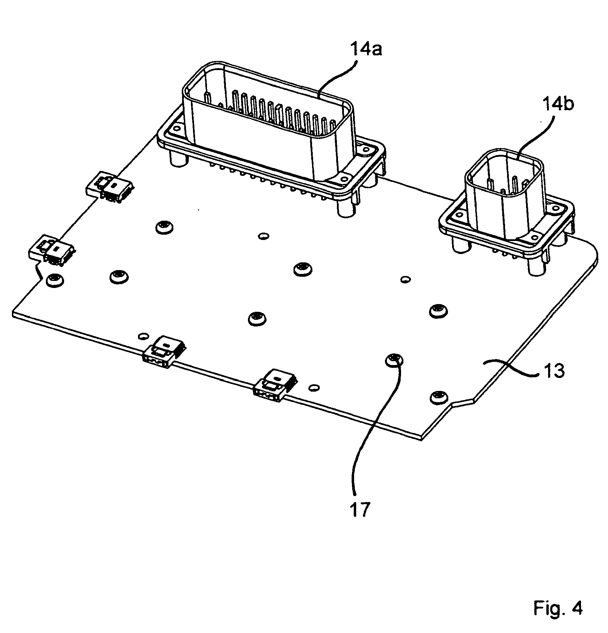

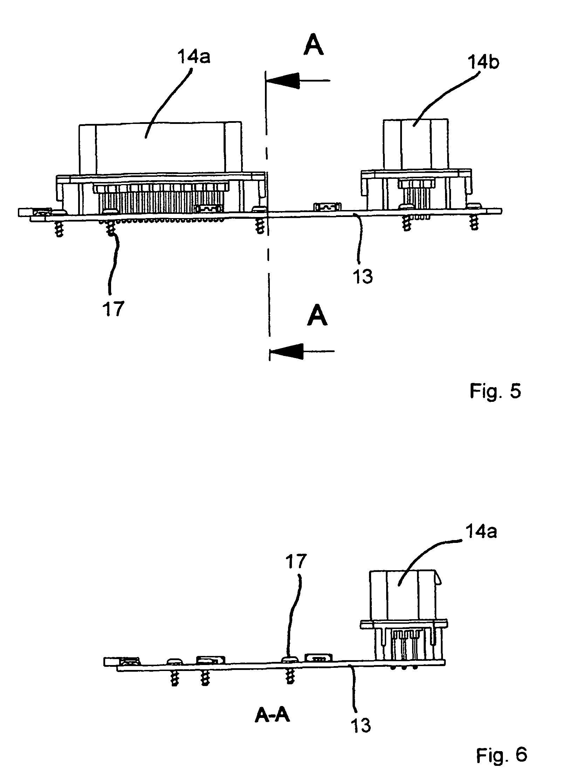

Die Fig. 4 bis 6 zeigen die Steuerplatine 13 mit den daran vorgesehenen Buchsen 14a und 14b. Mit dem Bezugszeichen 17 sind erste Schrauben bezeichnet, welche zur Befestigung am Topteil 10 dienen.

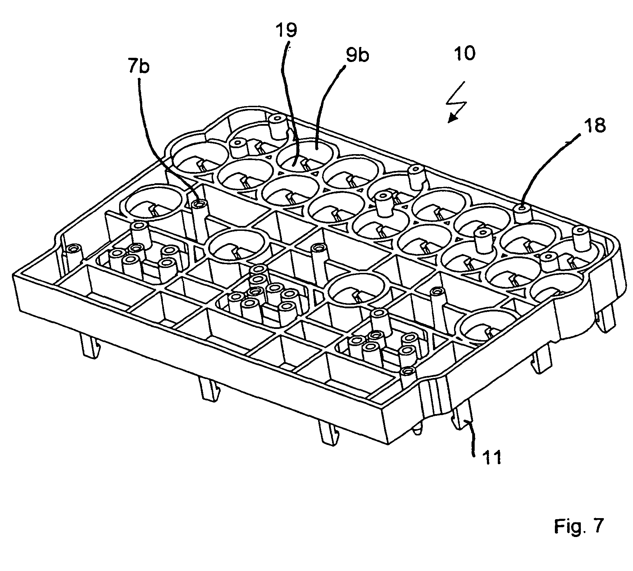

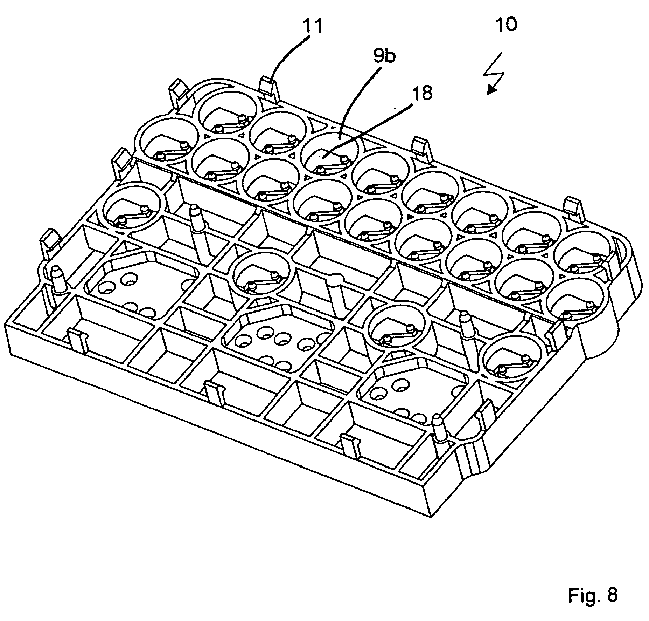

Die Fig. 7 und 8 zeigen perspektivische Ansichten des Topteils 10. Mit dem Bezugszeichen 18 sind zweite Ausnehmungen bezeichnet, welche zum Eingriff der ersten Schrauben 17 zur Befestigung der Steuerplatine 13 dienen. In weitere dritte Ausnehmungen 9b ragen Federzungen 19, mit denen die Kondensatoren 6a gehalten werden.

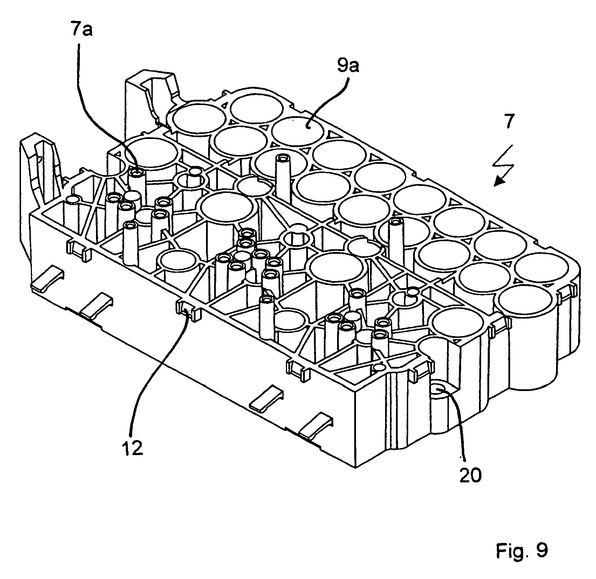

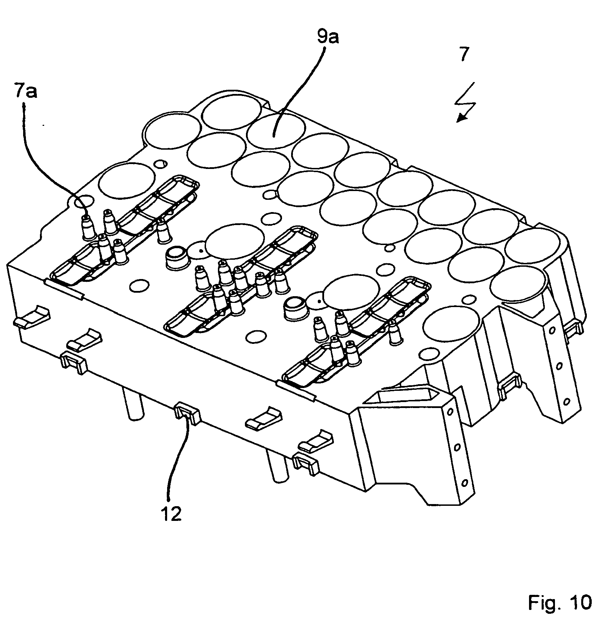

Die Fig. 9 und 10 zeigen perspektivische Ansichten des Basisteils 7. Das Basisteil 7 weist u. a. randlich angeordnete vierte Ausnehmungen 20 auf, durch welche zur Fixierung des Basisteils 7 an der Grundplatte 1 (hier nicht gezeigte) zweite Schrauben hindurchgeführt werden können.

Die Montage des Halbleitermoduls ist wie folgt:
Zur Herstellung einer ersten Montageeinheit wird die Steuerplatine 13 mittels der ersten Schrauben 17 mit dem Topteil 10 verbunden.

Zur Herstellung einer zweiten Montageeinheit wird zunächst auf die Grundplatte 1 der Montagerahmen 3 aufgelegt. Sodann werden in am Montagerahmen 3 vorgesehene Durchbrüche die Leistungshalbleiterplatinen 2 eingelegt. Anschließend werden die Anschlussplatten 4 auf die Leistungshalbleiterplatinen 2 gelegt. Dabei durchgreifen weitere Durchbrüche in den Anschlussplatten 4 die Anschlusselemente 5. Auf die Anschlussplatten 4 wird die Anschlussplatinenanordnung 6 aufgelegt. Darüber wird die Elastomermatte 16 gestapelt. Schließlich wird das Basisteil 7 so auf die Elastomermatte 16 gelegt, dass die auf die Anschlussplatinenanordnung 6 montierten Kondensatoren 6a in die dritten Ausnehmungen 9a im Basisteil 7 sich erstrecken. Anschließend wird das Basisteil 7 gegen die Grundplatte 1 gedrückt, so dass die Elastomermatte 16 komprimiert wird. In diesem Zustand wird das Basisteil 7 mittels durch die vierten Ausnehmungen 20 hindurchgeführter (hier nicht gezeigter) zweiter Schrauben mit der Grundplatte 1 verschraubt.

In den ersten Ausnehmungen 7a sind die Kontaktfedern 8 aufgenommen. Sie ragen über die ersten Ausnehmungen 7a hinaus. Die im Topteil 10 vorgesehenen weiteren ersten Ausnehmungen 7b sind mit Kontakten an der Unterseite der Steuerplatine 13 ausgerichtet.

In einem weiteren Montageschritt wird die erste Montageeinheit so auf das Basisteil 7 aufgesetzt, dass die aus den ersten Ausnehmungen 7a hervorstehenden Kontaktfedern 8 in die weiteren ersten Ausnehmungen 7b am Topteil 10 eingreifen. Dann wird das Topteil 10 gegen das Basisteil 7 gedrückt, bis die Rastzungen 11 mit den Rastausnehmungen 12 am Basisteil 7 verrasten. Durch die komprimierten Kontaktfedern 8 werden Kontakte zwischen der Steuerplatine 13 und der Leistungshalbleiterplatine 2 hergestellt. Die bei der Montage des ersten Montageteils erforderliche Kraft entspricht einer Kraft, welche zur Kompression der Kontaktfedern 8 erforderlich ist. Diese Kraft ist nicht allzu hoch. Infolgedessen und infolge der Anbringung der Steuerplatine 13 auf dem Topteil 10 wird sicher und zuverlässig eine Beschädigung der Steuerplatine 13 durch die Einwirkung der zur Montage erforderlichen Kraft vermieden.

In einem abschließenden Montageschritt wird das Gehäuse 15 mit der Grundplatte 1 verbunden.

### Bezugszeichenliste

- 1: Grundplatte
- 2: Leistungshalbleiterplatine
- 3: Montagerahmen
- 4: Anschlussplatte
- 5: Anschlusselement
- 6: Anschlussplatinenanordnung
- 6a: Kondensator
- 7: Basisteil
- 7a: erste Ausnehmung
- 7b: weitere erste Ausnehmung
- 8: Kontaktfeder
- 9a: dritte Ausnehmung
- 9b: weitere dritte Ausnehmung
- 10: Topteil
- 11: Rastzunge
- 12: Rastausnehmung
- 13: Steuerplatine
- 14a: erste Buchse
- 14b: zweite Buchse
- 15: Gehäuse
- 16: Elastomermatte
- 17: erste Schraube
- 18: zweite Ausnehmung
- 19: Federzunge
- 20: vierte Ausnehmung

## Patentansprüche

1. Leistungshalbleitermodul mit einer
Grundplatte (1),
zumindest einer auf der Grundplatte (1) aufliegenden, mit Leistungshalbleitern bestückten Leistungshalbleiterplatine (2),
einem darüber angeordneten, erste Ausnehmungen (7a) zur Aufnahme von Kontaktfedern (8)aufweisenden Zwischenstück, und
einer auf dem Zwischenstück angebrachten, eine Steuerschaltung aufweisenden Steuerplatine (13), wobei
das Zwischenstück mehrteilig ausgebildet ist und ein der Grundplatte (1) zugewandtes Basisteil (7) sowie ein der Steuerplatine (13) zugewandtes Topteil (10) aufweist,
**dadurch gekennzeichnet, dass** das Topteil (10) eine erste Befestigungseinrichtung zum Befestigen der Steuerplatine (13) und eine zweite Befestigungseinrichtung zum Befestigen am Basisteil (7) aufweist, wobei zwischen der Leistungshalbleiterplatine (2) und dem Basisteil (7) in übereinander liegender Anordnung zumindest eine Anschlussplatte (4), eine Bauelemente tragende Anschlussplatinenanordnung (6) und eine Elastomermatte (16) angeordnet sind.

2. Leistungshalbleitermodul nach Anspruch 1, wobei die ersten Ausnehmungen (7a, 7b) anteilig im Top- (10) und im Basisteil (7) gebildet sind.

3. Leistungshalbleitermodul nach einem der vorhergehenden Ansprüche, wobei die erste Befestigungseinrichtung zweite Ausnehmungen (18) zur Befestigung, vorzugsweise selbstschneidender, Schrauben (17) aufweist.

4. Leistungshalbleitermodul nach einem der vorhergehenden Ansprüche, wobei die zweite Befestigungseinrichtung eine Rasteinrichtung ist.

5. Leistungshalbleitermodul nach Anspruch 4, wobei die Rasteinrichtung mehrere am Topteil (10) angebrachte Rastzungen (11) umfasst, welche korrespondierend zu am Basisteil (7) vorgesehenen Rastausnehmungen (12) ausgebildet sind.

6. Leistungshalbleitermodul nach einem der Ansprüche 4 und 5, wobei die Rasteinrichtung so ausgebildet ist, dass eine damit hergestellte Rastverbindung zwischen dem Top- (10) und dem Basisteil (7) nicht zerstörungsfrei lösbar ist.

7. Leistungshalbleitermodul nach einem der vorhergehenden Ansprüche, wobei im Basisteil (7) dritte Ausnehmungen (9a) zur Aufnahme von Bauelementen, vorzugsweise zur Aufnahme zylindrischer Kondensatoren (6a), vorgesehen sind.

8. Leistungshalbleitermodul nach Anspruch 7, wobei im Topteil (10) zu den dritten Ausnehmungen (9a) korrespondierende weitere dritte Ausnehmungen (9b) zur Aufnahme der Bauelemente vorgesehen sind.

9. Leistungshalbleitermodul nach Anspruch 8, wobei sich in die weiteren dritten Ausnehmungen (9b) jeweils zumindest eine, vorzugsweise zwei, Federzunge/n (19) erstrecken.

10. Verfahren zur Montage eines Leistungshalbleitermoduls nach einem der vorhergehenden Ansprüche mit folgenden Schritten:
Herstellen einer ersten Montageeinheit durch Befestigen der Steuerplatine (13) am Topteil (10),
Anordnen der zumindest einen Leistungshalbleiterplatine (2) auf der Grundplatte (1),
Herstellen einer zweiten Montageeinheit durch Anordnen des Basisteils (7) über der Elastomermatte (16), der Anschussplatinenanordrung (6), der Anschlussplatte (4) und der Leistungshalbleiterplatine (2) und Befestigen des Basisteils (7) an der Grundplatte (1), und
Drücken der ersten Montageeinheit gegen die zweite Montageeinheit mit einer vorgegebenen Kraft, so dass in den ernsten Ausnehmungen (7a, 7b) aufgenommene Kontaktfedern (8) komprimiert werden, und währenddessen Befestigen des Topteils (10) am Basisteil (7) .

11. Verfahren nach Anspruch 10, wobei das Basisteil (7) mit der Grundplatte (1) verschraubt wird.

12. Verfahren nach Anspruch 10 oder 11, wobei die Steuerplatine (13) mit dem Topteil (10) verschraubt wird.

13. Verfahren nach einem der Ansprüche 10 bis 12 wobei das Basisteil (7) zusammen mit in den ersten Ausnehmungen (7a, 7b), vorzugsweise unverlierbar, aufgenommenen Kontaktfedern (8) über der Leistungshalbleiterplatine (2) angeordnet wird.

14. Verfahren nach einem der Ansprüche 10 bis 13, wobei vor dem Anordnen des Basisteils (7) über der Leistungshalbleiterplatine (2) in übereinander liegender Anordnung die zumindest eine Anschlussplatte (4), die Bauelemente, vorzugsweise Kondensatoren (6a), tragende Anschlussplatinenanordnung (6) und die Elastomermatte (16) angeordnet sind.

15. Verfahren nach einem der Ansprüche 10 bis 14, wobei zur Herstellung der zweiten Montageeinheit das Basisteil (7) mit einer vorgegebenen weiteren Kraft gegen die Grundplatte (1) gedrückt und währenddessen daran befestigt wird.

16. Verfahren nach einem der Ansprüche 10 bis 15, wobei beim Drücken der ersten Montageeinheit gegen die zweite Montageeinheit das Topteil (10) mittels einer Rasteinrichtung mit dem Basisteil (7) verrastet wird.

17. Verfahren nach einem der Ansprüche 10 bis 16, wobei die erste und/oder zweite Montageeinheit vor deren Verbindung geprüft werden.

## Claims

1. Power semiconductor module having a base plate (1),
at least one power semiconductor board (2) which rests on the base plate (1) and is fitted with power semiconductors,
an intermediate piece which has first recesses (7a) arranged thereabove for holding contact springs (8) and
a control board (13) which is fitted to the intermediate piece and has a control circuit, wherein
the intermediate piece is formed from a plurality of parts and has a base part (7), which faces the base plate (1), as well as a top part (10), which faces the control board (13),
**characterized in that**
the top part (10) has a first fastening device for fastening the control board (13), and has a second fastening device for fastening to the base part (7), wherein at least one connecting plate (4), a connecting board arrangement (6) to which components are fitted, and an elastomer mat (16) are arranged one above the other between the power semiconductor board (2) and the base part (7).

2. Power semiconductor module according to Claim 1, wherein some of the first recesses (7a, 7b) are formed in the top part (10), and some in the base part (7).

3. Power semiconductor module according to one of the preceding claims, wherein the first fastening device has second recesses (18) for fastening, preferably self-tapping, screws (17).

4. Power semiconductor module according to one of the preceding claims, wherein the second fastening device is a latching device.

5. Power semiconductor module according to Claim 4, wherein the latching device has a plurality of latching tongues (11) which are fitted to the top part (10) and are designed to correspond to latching recesses (12) which are provided on the base part (7) .

6. Power semiconductor module according to one of Claims 4 and 5, wherein the latching device is designed such that a latching connection which has been produced in this way between the top part (10) and the base part (7) cannot be detached without destroying it.

7. Power semiconductor module according to one of the preceding claims, wherein third recesses (9a) are provided in the base part (7), in order to hold components, preferably in order to hold cylindrical capacitors (6a).

8. Power semiconductor module according to Claim 7, wherein further, third recesses (9b), which correspond to the third recesses (9a), are provided in the top part (10), in order to hold the components.

9. Power semiconductor module according to Claim 8, wherein at least one and preferably two spring tongues (19) extend into each of the further third recesses (9b).

10. Method for assembling a power semiconductor module according to one of the preceding claims, having the following steps:
production of a first assembly unit by fastening the control board (13) to the top part (10),
arrangement of the at least one power semiconductor board (2) on the base plate (1),
production of a second assembly unit by arranging the base part (7) above the elastomer mat element (16), the connecting board arrangement (6), the connecting plate (4) and the power semiconductor board (2) and by fastening the base part (7) to the base plate (1), and
pressing the first assembly unit against the second assembly unit with a predetermined force, such that contact springs (8) which are held in the first recesses (7a, 7b) are compressed, and the top part (10) is attached to the base part (7) during this process.

11. Method according to Claim 10, wherein the base part (7) is screwed to the base plate (1).

12. Method according to Claim 10 or 11, wherein the control board (13) is screwed to the top part (10).

13. Method according to one of Claims 10 to 12, wherein the base part (7) is arranged together with the contact springs (8), which are held, preferably captive, in the first recesses (7a, 7b), above the power semiconductor board (2).

14. Method according to one of Claims 10 to 13, wherein, before the base part (7) is arranged above the power semiconductor board (2), the at least one connecting plate (4), the connecting board arrangement (6) to which components, preferably capacitors (6a) are fitted, and the elastomer mat (16) are arranged one above the other.

15. Method according to one of Claims 10 to 14, wherein, in order to produce the second assembly unit, the base part (7) is pressed against the base plate (1) with a predetermined further force, and is fastened to it during this process.

16. Method according to one of Claims 10 to 15, wherein, while the first assembly unit is being pressed against the second assembly unit, the top part (10) is latched to the base part (7) by means of a latching device.

17. Method according to one of Claims 10 to 16, wherein the first and/or second assembly unit are/is tested before their connection.

## Revendications

1. Module à semi-conducteur de puissance comportant
une plaque de base (1),
au moins une plaquette semi-conductrice de puissance (2) équipée de semi-conducteurs de puissance disposée sur la plaque de base (1),
des premiers évidements (7a) disposés sur celle-ci pour recevoir une pièce intermédiaire présentant des ressorts de contact (8), et
une plaquette de commande (13) montée sur la pièce intermédiaire et présentant un circuit de commande, dans lequel
la pièce intermédiaire est réalisée en plusieurs parties et comprend une partie de base (7) tournée vers la plaque de base (1) ainsi qu'une partie supérieure (10) tournée vers la plaquette de commande (13),
**caractérisé en ce que** la partie supérieure (10) comprend un premier dispositif de fixation destiné à fixer la plaquette de commande (13) et un deuxième dispositif de fixation destiné à être fixé à la partie de base (7),
dans lequel au moins une plaquette de connexion (4), un agencement de plaquette de connexion (6) portant des composants et une feuille d'élastomère (16) sont disposés selon un agencement superposé entre la plaquette à semi-conducteur (2) et la partie de base (7) .

2. Module à semi-conducteur de puissance selon la revendication 1, dans lequel les premiers évidements (7a, 7b) sont formés de manière proportionnelle dans la partie supérieure (10) et la partie de base (7).

3. Module à semi-conducteur de puissance selon l'une quelconque des revendications précédentes, dans lequel le premier dispositif de fixation comprend des deuxièmes évidements (18) destinés à fixer des vis (17) qui sont de préférence auto-taraudeuses.

4. Module à semi-conducteur de puissance selon l'une quelconque des revendications précédentes, dans lequel le deuxième dispositif de fixation est un dispositif à encliquetage.

5. Module à semi-conducteur de puissance selon la revendication 4, dans lequel le dispositif à encliquetage comprend de multiples languettes d'encliquetage (11) montées sur la partie supérieure (10), qui sont réalisées de manière à correspondre à des évidements d'encliquetage (12) prévus dans la partie de base (7).

6. Module à semi-conducteur de puissance selon l'une quelconque des revendications 4 et 5, dans lequel le dispositif d'encliquetage est conçu de manière à ce qu'une liaison d'encliquetage établie au moyen de celui-ci entre la partie supérieure (10) et la partie de base (7) ne puisse pas être interrompue sans destruction.

7. Module à semi-conducteur de puissance selon l'une quelconque des revendications précédentes, dans lequel des troisièmes évidements (9a) destinés à recevoir des composants, de préférence destinés à recevoir des condensateurs cylindriques (6a), sont prévus dans la partie de base (7).

8. Module à semi-conducteur de puissance selon la revendication 7, dans lequel d'autres troisièmes évidements (9b) destinés à recevoir les composants sont prévus dans la partie supérieure (10) d'une manière qui correspond aux troisièmes évidements (9a).

9. Module à semi-conducteur de puissance selon la revendication 8, dans lequel au moins une et de préférence deux languette(s) à ressort (19) s'étend/s'étendent respectivement dans les troisièmes évidements (9b).

10. Procédé de montage d'un module à semi-conducteur de puissance selon l'une quelconque des revendications précédentes, comprenant les étapes consistant à :
réaliser une première unité de montage par fixation de la plaquette de commande (13) sur la partie supérieure (10),
disposer l'au moins une plaquette à semi-conducteur de puissance (2) sur la plaque de base (1),
réaliser une deuxième unité de montage en disposant la partie de base (7) sur la feuille d'élastomère (16), l'agencement de plaquettes de connexion (6), la plaque de connexion (4) et la plaquette à semi-conducteur de puissance (2) et fixer la partie de base (7) à la plaque de base (1), et
comprimer la première unité de montage contre la deuxième unité de montage à l'aide d'une force prédéterminée de manière à ce que des ressorts de contact (8) reçus dans les premiers évidements (7a, 7b) soient comprimés, et pendant cela, à fixer la partie supérieure (10) à la partie de base (7).

11. Procédé selon la revendication 10, dans lequel la partie de base (7) est vissée dans la plaque de base (1).

12. Procédé selon la revendication 10 ou 11, dans lequel la plaquette de commande (13) est vissée dans la partie supérieure (10).

13. Procédé selon l'une quelconque des revendications 10 à 12, dans lequel la partie de base (7), en association avec les ressorts de contact (8) reçus, de préférence de manière non amovible, dans les premiers évidements (7a, 7b), est disposée sur la plaquette à semi-conducteur de puissance (2).

14. Procédé selon l'une quelconque des revendications 10 à 13, dans lequel, avant de placer la partie de base (7) sur la plaquette à semi-conducteur de puissance (2), l'au moins une plaque de connexion (4), l'agencement de plaquettes de connexion (6) portant les composants, qui sont de préférence des condensateurs (6a), et la feuille d'élastomère (16) sont disposés selon un agencement superposé.

15. Procédé selon l'une quelconque des revendications 10 à 14, dans lequel la partie de base (7) est comprimée à l'aide d'une autre force prédéterminée contre la plaque de base (1) et, pendant cela, y est fixée pour réaliser la deuxième unité de montage.

16. Procédé selon l'une quelconque des revendications 10 à 15, dans lequel, lors de la compression de la première unité de montage contre la deuxième unité de montage, la partie supérieure (10) est encliquetée dans la partie de base (7) au moyen d'un dispositif d'encliquetage.

17. Procédé selon l'une quelconque des revendications 10 à 16, dans lequel la première et/ou la deuxième unité(s) de montage est/sont testée(s) avant sa/leur connexion.
